**Europäisches Patentamt**

**European Patent Office**

**Office européen des brevets**

(19)

(11) Veröffentlichungsnummer: **0 108 201**
**B1**

(12)

# EUROPÄISCHE PATENTSCHRIFT

(45) Veröffentlichungstag der Patentschrift:
**09.04.86**

(51) Int. Cl.⁴: **C 23 C 18/24**

(21) Anmeldenummer: **83108043.7**

(22) Anmeldetag: **13.08.83**

(54) Verfahren zur Vorbehandlung von carbonamidgruppenhaltigen thermoplastischen Kunststoffen zur Herstellung von festhaftenden Metallüberzügen.

(30) Priorität: **16.09.82 DE 3234363**

(43) Veröffentlichungstag der Anmeldung:
**16.05.84 Patentblatt 84/20**

(45) Bekanntmachung des Hinweises auf die Patenterteilung:
**09.04.86 Patentblatt 86/15**

(84) Benannte Vertragsstaaten:
**AT BE CH DE FR GB IT LI LU NL SE**

(56) Entgegenhaltungen:
**US - A - 4 349 421**

**GALVANOTECHNIK, Band 72, Nr. 10, Oktober 1981, Seiten 1048-1054, Saulgau, DE E. GRÜNWALD u.a.: "Einige Beobachtungen über das Galvanisieren von ABS-Kunststoffen"**

(73) Patentinhaber: **HÜLS AKTIENGESELLSCHAFT, Patentabteilung / PB 15 - Postfach 13 20, D-4370 Marl 1 (DE)**

(72) Erfinder: **Gätzschmann, Horst, Ahornstrasse 60, D-4235 Schermbeck (DE)**
Erfinder: **Bertels, Herbert, Emslandstrasse 5, D-4370 Marl (DE)**
Erfinder: **Häfner, Hubertus, Glatzer Strasse 27, D-4370 Marl (DE)**
Erfinder: **Schmid, Alfred, Lipper Weg 195, D-4370 Marl (DE)**

## Beschreibung

Gegenstand der Erfindung ist ein verbessertes Verfahren zur Vorbehandlung von anorganischen feinteiligen Haftfüllstoff enthaltenden carbonamidgruppenhaltigen Kunststoffen mit mindestens 10 aliphatisch gebundenen Kohlenstoffatomen je Carbonamidgruppe, beispielsweise Polyundecansäureamid (10 C-Atome pro Carbonamidgruppe) oder insbesondere Polylaurinlactam (11 C-Atome pro Carbonamidgruppe) zur Herstellung festhaftender Metallüberzüge.

Die elektrochemische Beschichtung von thermoplastischen Kunststoffen mit Metallen ist grundsätzlich bekannt. Insbesondere haben sich hier als Thermoplaste sogenannte ABS-Copolymerisate (Acrylnitril-Butadien-Styrol-Copolymerisate) oder Polyolefine, insbesondere Polypropylen, bewährt. Polyamide erfordern wegen ihres polaren Charakters und wegen ihrer Wasseraufnahme eine besondere Behandlung. Die bekannten Verfahren konnten daher noch nicht befriedigen.

Vor der eigentlichen galvanischen Metallabscheidung erfolgt bekanntlich eine notwendige Vorbehandlung des Kunststoffs, um die Haftstellen für das Metall vorzubereiten. Dieser Arbeitsablauf erfolgt in entsprechenden Bädern mit spülender Zwischenbehandlung. Allgemein läßt sich etwa folgender Arbeitsablauf darstellen: Nach dem Reinigen und Entfetten werden an der Oberfläche des zu beschichtenden Formteils zunächst in einem meist sauren Bad zahlreiche Mikrokavernen erzeugt (Beizen oder Aufrauhen). Es wird auch empfohlen, diesen hier als Beizen bezeichneten Schritt in Teilschritten vorzunehmen. Dabei wird in einem ersten Bad die Oberfläche angequollen, was als Vortauchen bezeichnet wird, und in einem zweiten Bad die eigentliche Aufrauhung, das Beizen, durchgeführt. Danach erfolgt ein Aktivieren, z. B. durch Abscheiden von Silber- oder Palladiumkeimen, die dann die Abscheidung einer elektrisch leitföhigen Schicht ermöglichen, beispielsweise durch reduzierendes Abscheiden von Kupfer oder Nickel. Danach erfolgt das galvanische Abscheiden von Metallen. Zwischen den einzelnen Schritten wird in üblicher Weise, wie bereits erwöhnt, gespült.

Es ist auch bekannt, daß es vorteilhaft ist, dem Kunststoff feinteilige anorganische Füllstoffe, im Folgenden als Haftfüllstoffe bezeichnet, im Unterschied zu anderen Füllstoffen, zuzumischen. Diese führen einmal zu einer rauheren Oberfläche, die sich in der Metallschicht abzeichnet, und zum anderen, sofern sie von Säuren angreifbar sind, bilden sie bei der Vor- und Zwischenbehandlung zusätzlich Mikrokavernen (DBP 16 21 072). Schließlich ist es auch bekannt, dem zu metallisierenden Kunststoff ein Kunststoffkonzentrat zuzumischen, das ein anorganisches Feinpulver enthält, das zumindestens teilweise in Schwefelsäure löslich ist und neben dem Kunststoff Steinkohleteerpech enthält (DBP 22 16 330). Abgesehen davon, daß der Zusatz von Steinkohleteerpech in dem Konzentrat wegen seiner kanzerogenen Wirkung nicht zu vertreten ist, führt auch der Zusatz von den genannten Kohlenwasserstoffpolymeren, wie Polypropylen, zu Unvertröglichkeiten in der Mischung und damit zu erheblichen inneren Spannungen und folglich zu verminderter Haftfestigkeit der aufzubringenden Metallschicht. Obwohl in dem DBP 22 16 330 auch der Zusatz zu Polyamid-12 empfohlen wird, konnten beim Nacharbeiten keine haftfesten Metallüberzüge erhalten werden.

Aufgabe der Erfindung ist, ein Verfahren zur Vorbehandlung bereitzustellen, das bei thermoplastischen carbonamidgruppenhaltigen Kunststoffen mit mindestens 10 Kohlenstoffatomen pro Carbonamidgruppe zu glatten, haftfesten Metallüberzügen führt. Die Lösung dieser Aufgabe gelingt durch die Maßnahmenfolge gemäß der patentansprüche. Wesentlich für den Erfolg des Verfahrens ist die Kombination der Maßnahmen.

Als geeignete thermoplastische carbonamidgruppenhaltige Kunststoffe (Formmassen) seien genannt Homopolyamide, wie Polyundecansäureamid, insbesondere Polyamid-12 (Polylaurinlactam). Geeignet sind Spritzgieß- und Extrusionstypen, insbesondere solche mit Viskositätszahlen von 120 bis 260 (DIN 53 727), entsprechend ein $\eta_{rel}$-Wert von 1,6 bis 2,3. Copolyamide, welche die genannten monomeren Bausteine in überwiegender Menge enthalten sowie Polyesteramide auf Basis der genannten Polyamidbausteine sind weniger bevorzugt.

Der zu beschichtende Kunststoff wird zweckmäßig als Formmasse zu dem zu beschichtenden Formkörper verarbeitet, die bereits den Haftfüllstoff enthalten. Bevorzugte Haftfüllstoffe sind pulverförmige Zeolithe oder pulverförmiges Calciumcarbonat.

Die Herstellung der Formmasse geschieht zweckmäßig durch Umschmelzen des Kunststoffgranulates oder -pulvers zusammen mit dem Füllstoffpulver in einem Schneckenkneter. Es ist auch möglich, das Haftfüllstoffpulver in die Kunststoffschmelze zu dosieren und anschließend zu granulieren. Falls erforderlich, können die Kunststoffe auch Stabilisatoren, Gleitmittel, Entformungshilfsmittel, Weichmacher, Farbstoffe oder andere Füllstoffe, welche keine sogenannten Haftfüllstoffe sind, wie Titandioxid, Talkum, Wollastonit, Quarzmehl, calciniertes Kaolin, Glimmer, Glasfaser mit partikelgrößen bis höchstens 10 µm, in üblichen Mengen enthalten.

Die Menge des zugesetzten Haftfüllstoffs beträgt 1 bis 45 Gewichtsprozent, bezogen auf den Kunststoff, vorzugsweise 2 bis 20, insbesondere 3 bis 10 Gewichtsprozent. Die Teilchengröße des Haftfüllstoffpulvers beträgt 0,05 bis 5 µm, wobei diese bei den Zeolithen 1 bis 5 µm und bei dem Calciumcarbonat 0,05 bis 1 µm beträgt. Bevorzugt sind die feinteiligen Pulver mit einer Teilchen-größe von 0,05 bis 1 µm, d. h. besonders vorteilhaft veiwendet man Calciumcarbonat.

Die Gesamtmenge aus Füllstoff und Haftfüllstoff kann 1 bis 100 Gewichtsprozent, bezogen auf den Kunststoff, betragen. Vorzugsweise beträgt die Gesamtmenge 2 bis 75, insbesondere 3 bis 65 Gewichtsprozent. Mit anderen Worten beträgt der Anteil des Haftfüllstoffes am Gesamtfüllstoffgehalt 2 bis 100, vorzugsweise 4 bis 100, insbesondere 6 bis 100 Gewichtsprozent. Die Zusatzfüllstoffe sollen in Schwefelsäure praktisch nicht löslich sein. Es ist somit möglich, durch den Einsatz relativ geringer Mengen an sogenanntem Haftfüller in Verbindung mit anderen Füllstoffen eine Verbesserung der Haftung der galvanisch aufgebrachten Metallschicht zu erzielen.

Wegen des Wasserrückhaltever mögens, insbesondere bei Anwesenheit von Zeolithen, ist es vorteilhaft, bei der Polymerisation geregelte Kunststoffe zu verwenden, die durch Trocknen bei der Formgebung zu dem gewünschten Polymerisationsgrad nachkondensieren. Der Polymerisationsgrad solcher Kunststoffe liegt ausgedrückt durch den $\eta_{rel}$-Wert im Bereich von 1,50 bis 2,00, vorzugsweise 1,6 bis 1,9, insbesondere 1,7 bis 1,8.

Als Vortauchmittel wird 50 bis 96 %ige, vorteilhaft 60 bis 70 %ige Schwefelsäure eingesetzt, die als Zusätze bekannte Netzmittel enthalten, beispielsweise solche, wie Kaliumperfluoralkylsulfonat. Wesentlich für die Arbeitsweise der Erfindung ist, daß die Oberflächenspannung der Vortauchlösung auf mindestens 25 mN/m (gemessen bei 20 °C) herabgesetzt werden muß, mit anderen Worten, es muß mit höheren Netzmittelkonzentrationen als nach dem Stand der Technik gearbeitet werden. Vorteilhaft liegt die Oberflächenspannung bei 16 bis 25, insbesondere bei 19 bis 22 mN/m (gemessen bei 20°C).

Schließlich ist ein weiterer erfindungswesentlicher Schritt das Zwischentrocknen vor der Metallbeschichtung. Die Zwischentrocknung wird zweckmäßigerweise nach der chemischen Metallabscheidung durchgeführt; es kann jedoch auch schon nach dem Aktivieren getrocknet werden. Dies geschieht nicht wegen der erwähnten Nachkondensation, sondern hat sich bei allen eingesetzten Kunststoffen als notwendig erwiesen.

Diese sogenannte Zwischentrocknung erfolgt bei Temperaturen von 70 bis zur Grenze der Formbeständigkeit, insbesondere von 90 bis 110 °C. Die Trocknungsdauer hängt naturgemäß von der Höhe der Temperatur ab und liegt im allgemeinen bei 90 °C im Bereich von 30 Minuten und bei 110°C im Bereich von 10 Minuten.

Die beschichteten Formkörper werden geprüft nach dem Hafttest gemäß DIN 53 494, wobei die Abzugskraft gemessen wird, um einen 25 mm breiten Metallfilm von dem Kunststoff zu trennen. Ferner wird für thermisch beanspruchte Teile die Temperaturwechselprüfung nach DIN 53 496 ausgeführt.

**Beispiel 1**

Eine Formmasse aus 100 Gewichtsteilen polyamid-12, $\eta_{rel}$ 1,9, und 5 Gewichtsteilen eines Zeolithpulvers mit einer durchschnittlichen Teilchengröße von 2 µm bzw. 5 Gewichtsteilen Calciumcarbonat mit einer durchschnittlichen Teilchengröße von 0,07 µm wird zunächst 2 bis 5 Minuten in einer 60 %igen Schwefelsäure, deren Oberflächenspannung auf 19 bis 22 mN/m herabgesetzt worden war, bei Raumtemperatur vorgetaucht und anschließend 0,5 bis 2 Minuten in fließendem, vollentsalztem Wasser gespült und dann 0,5 bis 3 Minuten in einer Beizlösung aus Chromschwefelsäure bei Raumtemperatur aufgerauht. Nachdem die Proben 0,5 bis 3 Minuten bei Raumtemperatur in vollentsalztem Wasser gespült und 2 bis 10 Minuten in einer ca. 25 %igen Salzsäurelösung bei Raumtemperatur reduziert wurden, wird die Formmasse zunächst 5 bis 20 Minuten in Wasser bei 40 bis 90 °C und anschließend in vollentsalztem Wasser 0,5 bis 2 Minuten bei Raumtemperatur gespült, worauf sie in einem handelsüblichen Aktivatorsystem (Sn/Pd bzw. Sn/Ag) bekeimt wird. Auf die so vorbereiteten Proben wird in einem chemisch arbeitenden Kupferbad 0,2 bis 0,5 µm Kupfer abgeschieden. Nach einer Trocknung bei 90 bis 110 °C von 10 bis 30 Minuten in einem Umlufttrockenschrank werden die proben elektrolytisch mit Kupfer verstärkt.

Ergebnis: Die Haftfestigkeit der abgeschiedenen Kupferschicht lag bei bis zu 80 N/25 mm, wobei ein Mittelwert von 60 N/25 mm ermittelt wurde. Die Temperaturwechselprüfung nach DIN 53 496, Beanspruchungsklasse A wurde bestanden.

**Beispiel 2**

Verwendet man eine Formmasse bestehend aus 100 Gewichtsteilen Polyamid-12 ($\eta_{rel}$ 1,9), 45 Gewichtsteilen Glimmer 4 Gewichtsteilen Calciumcarbonat (durchschnittlich 0,07 µm), 1 Gewichtsteil eines phenolischen Antioxydants und 0,3 Gewichtsteile Calciumstearat, werden gleich gute Ergebnisse erzielt (Schältest nach DIN 53 494, 70 N/25 mm).

**Vergleichsbeispiel 1**

Wird die Formmasse gemäß Beispiel 1 in einer 60 %igen Schwefelsäure, deren Oberflächenspannung jedoch 26 mN/m beträgt, in gleicher Weise vorgetaucht und wie in Beispiel 1 beschrieben weiterbehandelt, so wird eine unvollständige Kupferbeschichtung erhalten.

## Vergleichsbeispiel 2

Wird die Formmasse gemäß Beispiel 1 in gleicher Weise wie in Beispiel 1, jedoch ohne Zwischentrocknung, behandelt, so löst sich die Kupferschicht von der Oberfläche ab (sogenannte Blasenbildung).

## Vergleichsbeispiel 3

Werden anstelle von Polyamid-12 100 Gewichtsteile Poly-amid-6 bzw. 100 Gewichtsteile Polyamid-6,6 mit jeweils 5 Gewichtsteilen Zeolith bzw. 5 Gewichtsteilen Calciumcarbonat wie in Beispiel 1 beschrieben behandelt, so werden die Oberflächen trotz kurzer Vortauch- bzw. Beizzeiten zerfressen, so daß keine hinreichende Beschichtung zu erzielen ist.

In der folgenden Tabelle 1 sind die Ergebnisse weiterer Versuche (E 1 bis E 5) und Vergleichsversuche (V 1 bis V 4) zusammengestellt.

## Tabelle 1

| | Polyamid (PA) (DIN 53 727) $\gamma_{rel}$ | Haftfüllstoff Teilchengröße $\emptyset$ µm | Menge Gew.-Tl./100 Tl. PA | Füllstoff | Menge Gew.-Tl./100 Tl. PA | Vortauchen Oberflächensp. $mN/m^{-1}$ | Trocknen Temp. °C | Zeit min | Metall-[*] schältest DIN 53 494 N/25 mm | Temperatur- Wechseltest DIN 53 496 +80 °C/-50 °C | Bemerkungen |
|---|---|---|---|---|---|---|---|---|---|---|---|
| V 1 | PA-12 1,8 | Zeolith 2 | 5 | - | - | > 25. | 70 | 60 | | - | bereits nur partielle Abscheidung der red. abgesch. Schicht |
| V 2 | PA-12 1,8 | - | - | - | - | 19 - 22 | 120 | 30 | keine Haftung | - | |
| V 3 | PA-12 1,8 | Zeolith 2 | 5 | - | - | 19 - 22 | - | - | keine Haftung | - | |
| V 4 | PA-12 1,9 | - | - | Kaolin | 30 | 19 - 22 | 90 | 30 | keine Haftung | - | |

[*] Mittel aus 5 Messungen

**Tabelle 1** - Fortsetzung

| | Polyamid (PA) (DIN 53 727) $\gamma_{rel}$ | Haftfüllstoff Teilchengröße $\emptyset$ µm | Menge Gew.-Tl./100 Tl. PA | Füllstoff | Menge Gew.-Tl./100 Tl. PA | Vortauchen Oberflächensp. mN/m$^{-1}$ | Trocknen Temp. °C | Zeit min | Metall-* schältest DIN 53 494 N/25 mm | Temperatur- Wechseltest DIN 53 496 +80 °C/-50 °C | Bemerkungen |
|---|---|---|---|---|---|---|---|---|---|---|---|
| E 1 | PA-12 1,8 | Zeolith 2 | 4,8 | - | - | 19 - 22 | 90 | 30 | 55 | + | Oberfläche gut |
| E 2 | PA-12 1,8 | Zeolith 2 | 7,2 | - | - | 19 - 22 | 90 | 30 | 55 | + | Oberfläche gut |
| E 3 | PA-12 1,7 | Zeolith 2 | 4,8 | - | - | 19 - 22 | 90 | 30 | 55 | + | Oberfläche gut |
| E 4 | PA-12 1,8 | Calcium- carbonat 0,07 | 4,8 | - | - | 19 - 22 | 90 | 30 | 60 | + | Oberfläche gut |
| E 5 | PA-12 1,9 | Calcium- carbonat 0,07 | 3,3 | Kaolin | 30 | 19 - 22 | 90 | 30 | 60 | + | Oberfläche gut |

* Mittel aus 5 Messungen

**Patentansprüche:**

1. Verfahren zur Vorbehandlung von anorganischen, feinteiligen, Haftfüllstoff enthaltenden, thermoplastischen, carbonamidgruppenhaltigen Kunststoffen mit mindestens 10 aliphatisch gebundenen Kohlenstoffatomen pro Carbonamidgruppe zur Herstellung von festhaftenden Metallüberzügen durch Behandeln mit einem Beizmittel und, nach einer Aktivierung, Aufbringen einer elektrisch leitenden Schicht mit nachfolgender galvanischer Abscheidung, dadurch gekennzeichnet, daß der Beizvorgang in mindestens zwei getrennten Schritten erfolgt, zwischen denen ein Spülvorgang eingeschaltet wird, wobei der erste Schritt, (das Vortauchen), in einer 50 bis 96 %igen Schwefelsäure vorgenommen wird, deren Oberflächenspannung höchstens 25 mN/m beträgt (gemessen bei 20° C) und nach der Aktivierung oder nach dem Aufbringen der elektrisch leitenden Schicht vor der galvanischen Metallabscheidung der vorbehandelte Kunststoff bei Temperaturen von 70 °C bis zur Grenze der Formbeständigkeit getrocknet wird.

2. Verfahren nach Anspruch 1, dadurch gekennzeichnet, daß der vorbehandelte Kunststoff bei Temperaturen von 70 bis 110 °C getrocknet wird.

3. Verfahren nach den Ansprüchen 1 und 2, dadurch gekennzeichnet, daß der Kunststoff als anorganischen Haftfüllstoff, bezogen auf den Kunststoff, 1 bis 45 Gewichtsprozent Calciumcarbonat und/oder Zeolithe mit einer Teilchen-größe von 0,05 bis 5 μm enthält.

4. Verfahren nach Anspruch 3, dadurch gekennzeichnet, daß der Haftfüllstoff in Mengen von 2 bis 20 Gewichtsprozent, bezogen auf den Kunststoff, eingesetzt wird.

5. Verfahren nach den Ansprüchen 3 und 4, dadurch gekennzeichnet, daß als Haftfüllstoff Calciumcarbonatpulver mit einer Teilchengröße von 0,05 bis 1,0 μm eingesetzt wird.

**Revendications**

1. Procédé pour le prétraitement de matières synthétiques thermoplastiques à groupes carboxamide comportant au moins 10 atomes de carbone en liaison aliphatique par groupe carboxamide, contenant de la charge minérale d'adhérence en fines particules, pour la réalisation de revêtements métalliques fermement adhérents, par traitement avec un décapant et, après une activation, application d'une couche électriquement conductrice avec depôt galvanique subséquent, caractérisé par le fait que le processus de décapage a lieu en au moins deux étapes séparées entre lesquelles on intercale un processus de rinçage, qu'on effectue la première étape (la pré-immersion) dans un acide sulfurique à 50 à 96 % dont la tension superficielle est au maximum de 25 mN/m (mesurée à 20° C) et qu'après l'activation ou après l'application de la couche électriquement conductrice, avant le depôt galvanique de métal, on sèche la matière synthétique prétraitée à des températures allant de 70° C jusqu'à la limite de la stabilité de forme.

2. Procédé selon la revendication 1, caractérisé par le fait que l'on sèche la matière synthétique prétraitée à des températures de 70 à 110° C.

3. Procédé selon les revendications 1 et 2, caractérisé par le fait que la matière synthétique contient comme charge minérale d'adhérence, relativement à la matière synthétique, de 1 à 45 % en poids de carbonate de calcium et/ ou de zéolites d'une grosseur de particules de 0,05 à 5 μm.

4. Procédé selon la revendication 3, caractérisée par le fait que l'on utilise la charge d'adhérence à raison de 2 à 20 % en poids, relativement à la matière synthétique.

5. Procédé selon les revendications 3 et 4, caractérisé par le fait que l'on utilise comme charge d'adhérence de la poudre de carbonate de calcium d'une grosseur de particules de 0,05 à 1,0 μm.

**Claims**

1. A process for the pre-treatment of a thermoplastic plastics material containing carbonamide groups with at least 10 aliphatically linked carbon atoms per carbonamide group, the material containing an inorganic, finely-divided, cohesive filler, for the manufacture of strongly adherent metal coatings, by treatment with an etching agent and, after activation, setting up an electrically conductive layer and subsequent galvanic deposition, characterised in that the etching treatment is carried out in at least two separate stages, between which a rinsing treatment is interpolated, the first stage (the preliminary immersion) being carried out in a 50 to 96% sulphuric acid whose surface tension is at most 25 mN/m (measured at 20° C)[2], and after the activation or after the setting up of the electrically conductive layer but before the galvanic metal deposition the pre-treated plastics material is dried at a temperature of from 70° C up to the limit before deformation occurs.

2. A process according to claim 1, characterised in that the pre-treated plastics material is dried at a temperature of from 70 to 110° C.

3. A process according to claim 1 or 2, characterised in that the plastics material contains as inorganic cohesive filler from 1 to 45% by weight, based on the plastics material, of calcium carbonate and/or zeolite having a particle size of from 0.05 to 5μm.

4. A process according to claim 3, characterised in that the cohesive filler is present in an amount of from 2 to 20% by weight, based on the plastics material.

5. A process according to claim 3 or 4, characterised in that calcium carbonate powder having a particle size of from 0.05 to 1.0μm is present as cohesive filler.